# EUROPEAN PATENT SPECIFICATION

(11) **EP 3 992 643 B1**
(45) Date of publication and mention of the grant of the patent: **25.09.2024**
(21) Application number: 20205139.7
(22) Date of filing: 02.11.2020
(51) Int. Cl.: G01R 31/00, G06N 3/04, G06N 3/08, G06N 3/044, G06N 3/045

(54) **METHODS AND SYSTEMS FOR DETERMINING A STATE OF AN ARRANGEMENT OF ELECTRIC AND/OR ELECTRONIC COMPONENTS**
VERFAHREN UND SYSTEME ZUR BESTIMMUNG EINES ZUSTANDS EINER ANORDNUNG ELEKTRISCHER UND/ODER ELEKTRONISCHER KOMPONENTEN
PROCÉDÉS ET SYSTÈMES POUR DÉTERMINER L'ÉTAT D'UN AGENCEMENT DE COMPOSANTS ÉLECTRIQUES ET/OU ÉLECTRONIQUES

(43) Date of publication of application: 04.05.2022
(73) Proprietor: Aptiv Technologies AG, 8200 Schaffhausen (CH)
(72) Inventor: YOUSEF, Sebastian, 44795 Bochum (DE); PETIG, Christof, 42369 Wuppertal (DE)
(74) Representative: Manitz Finsterwald Patent- und Rechtsanwaltspartnerschaft mbB

(56) References cited:
- CN-A- 108 535 566
- US-A1- 2020 081 070
- RASHID ROZEHA A ET AL: "Machine Learning for Smart Energy Monitoring of Home Appliances Using IoT", 2019 ELEVENTH INTERNATIONAL CONFERENCE ON UBIQUITOUS AND FUTURE NETWORKS (ICUFN), IEEE, 2 July 2019 (2019-07-02), pages 66 - 71, XP033600747, DOI: 10.1109/ICUFN.2019.8806026
- NANDA SANTOSH KUMAR ET AL: "Virtual instrument based fault classification in power transformers using artificial neural networks", 2013 IEEE 1ST INTERNATIONAL CONFERENCE ON CONDITION ASSESSMENT TECHNIQUES IN ELECTRICAL SYSTEMS (CATCON), IEEE, 6 December 2013 (2013-12-06), pages 169 - 173, XP032565072, DOI: 10.1109/CATCON.2013.6737492

## Description

### FIELD

The present disclosure relates to methods and systems for determining a state of an arrangement of electric and/or electronic components.

### BACKGROUND

Input currents of different loads and consumers, for example within a vehicle, are commonly supplied by relays and melting fuses, which however provide a slow and error-prone way of cutting loads and consumers from a current source.

Accordingly, there is a need to provide enhanced means to control loads and consumers.

CN108535566A discloses an electric appliance classification device. The electric appliance classification device comprises an information collection module, an information processing module and a communication module. Electric appliance starting current characteristics including starting swash current, starting average current and starting current impulse are adopted at the same time, and the load current spectrum characteristics of electric appliances are taken as identification and classification characteristics, so that the characteristic information is abundant; a combined classifier including a BP neural network classifier and a Bayes classifier is used for carrying out judgment classification, and judgment is carried out by giving consideration to the characteristics of the BP neural network classifier and the characteristics of the Bayes classifier.

Rashid Rozeha et al., "Machine Learning for Smart Energy Monitoring of Home Appliances Using IoT", 2019 Eleventh International Conference on Ubiquitous and Future Networks (ICUFN), IEEE, doi:10.1 109/ICUFN.2019.8806026, pages 66 - 71, discloses a smart energy monitoring system for home appliances incorporating CloT which consists of three parts. Firstly, a Raspberry Pi-based smart plug serving as the gateway, that is able to read current data from individual home appliances, load the trained model from training server and test the verified data using the model. Secondly, Google Colab as the training server will be used to store the training data set and building the Tensorflow-based Long Short-term Memory (LSTM) model. This recurrent neural network model forecasts electricity bill and notify users if abnormal energy consumption of individual home appliances is detected. Thirdly, a dashboard using Matplotlib library where users may monitor the real-time energy consumption.

### SUMMARY

The present disclosure provides a computer implemented method, a computer system, a vehicle, a battery charger, and a non-transitory computer readable medium according to the independent claims. Embodiments are given in the subclaims, the description and the drawings.

In one aspect, the present disclosure is directed at a computer implemented method for determining a state of an arrangement of electric and/or electronic components, the method comprising the following steps performed (in other words: carried out) by computer hardware components: determining a plurality of load current measurements of the arrangement; providing the plurality of load current measurements to a machine learning method; and determining the state of the arrangement based on the plurality of load current measurements using the machine learning method.

It will be understood that the load current is a current, for example a current is related to power consumed by one or more loads.

The method may provide a smart fuse technology for mainly automotive purpose using artificial neural networks. The method may improve and solve many problems of prior art techniques such as: being more focused on application peripherals and parameters of attached components like loads, wire harness and supply voltages; more flexible against environmental changes since there is no static threshold being compared to monitored current level; according to environmental changes (e.g. temperatures) the model can directly be exchanged by software; more complex current profile trends can be taken into account without loading processor CPU; and more detailed trend indications can be analyzed with smaller effort in the field application. Mainly decreased processor performance needed.

According to another aspect, determining the state of the arrangement comprises classifying the state of the arrangement into one of a plurality of classes.

According to another aspect, the classes comprise a class of overload state and a class of non-overload state. Thus, the method may be provided to provide input to an electronic fuse, for example a power switch, to determine overload situations, in which the switch shall disconnect the load from the supply.

According to another aspect, the classes comprise a class of fully charged and a class of not fully charged, or the classes comprise a plurality of classes corresponding to pre-determined percentages of full charging (for example classes for 0%, 25,%, 50%, 75%, and 100% of full charging, or classes of 0%, 10%, 20%, 30%, 40%, 50%, 60%, 70%, 80%, 90%, and 100% of full charging). Thus, the method may be provided for controlling charging, for example charging of a battery, for example a battery of a vehicle.

According to another aspect, the plurality of load current measurements comprises a plurality of series of load current measurements, each series comprising a pre-determined number of subsequent load current measurements. The pre-determined number of subsequent load current measurements may be provided subsequently in time. Each series may be referred to as a snapshot.

According to another aspect, the plurality of series may overlap in time. This may ensure that each of the plurality of load current measurements are treated in the context of the neighboring load current measurements.

According to another aspect, the machine learning method comprises a method using an artificial neural network. With the method, a load current profile classification with neural network implementation may be provided, for example for smart fusing. The smart fuse arrangement may be provided using a machine learning approach trained using an electronic load current profile classification system.

According to another aspect, the artificial neural network comprises a convolutional neural network.

According to another aspect, the convolutional neural network comprises a network with a 3x3 cascade.

According to another aspect, the artificial neural network comprises a long short-term memory.

In another aspect, the present disclosure is directed at a computer system, said computer system comprising a plurality of computer hardware components configured to carry out several or all steps of the computer implemented method described herein.

The computer system may comprise a plurality of computer hardware components (for example a processor, for example processing unit or processing network, at least one memory, for example memory unit or memory network, and at least one non-transitory data storage). It will be understood that further computer hardware components may be provided and used for carrying out steps of the computer implemented method in the computer system. The non-transitory data storage and/or the memory unit may comprise a computer program for instructing the computer to perform several or all steps or aspects of the computer implemented method described herein, for example using the processing unit and the at least one memory unit.

According to another aspect, the computer system further comprises a digital signal processor configured to carry out the machine learning method.

In another aspect, the present disclosure is directed at a vehicle comprising the computer system described herein and a sensor configured to determine the plurality of load current measurements of the arrangement.

In another aspect, the present disclosure is directed at a battery charger comprising the computer system as described herein and a sensor configured to determine the plurality of load current measurements of the arrangement. The battery charger may further include a voltage sensor configured to determine a voltage of the arrangement. The battery charger may further include a temperature r sensor configured to determine a temperature of the arrangement. The state of the arrangement may then be determined further based on the voltage and/or the temperature. The arrangement may be a battery.

The battery charger may control a current provided to the battery, for example using a pulse width modulation (PWM) of a current.

In another aspect, the present disclosure is directed at a non-transitory computer readable medium comprising instructions for carrying out several or all steps or aspects of the computer implemented method described herein. The computer readable medium may be configured as: an optical medium, such as a compact disc (CD) or a digital versatile disk (DVD); a magnetic medium, such as a hard disk drive (HDD); a solid state drive (SSD); a read only memory (ROM), such as a flash memory; or the like. Furthermore, the computer readable medium may be configured as a data storage that is accessible via a data connection, such as an internet connection. The computer readable medium may, for example, be an online data repository or a cloud storage.

Various aspects may be applicable for replacing electronic relay and fusing systems, and may be applicable for power supplies on vehicle system level or ECU (electronic control unit) internally (for example for the power tree).

Various aspects may provide a high performance smart fusing, and may provide an adaptable and intelligent switching and fusing which allows small margins for power tree and W/H (wiring harness).

With various aspects, cost reduction for vehicle systems will be possible,
The present disclosure is also directed at a computer program for instructing a computer to perform several or all steps or aspects of the computer implemented method described herein.

### DRAWINGS

Exemplary embodiments and functions of the present disclosure are described herein in conjunction with the following drawings, showing schematically:
- Fig. 1: a block diagram illustrating an electronic load current profile classification system according to various embodiments;
- Fig. 2: an illustration of overlap of load current measurements in various snapshots;
- Fig. 3: an illustration of a physical measurement and logging procedure according to various embodiments;
- Fig. 4: an illustration of how a machine learning model is trained;
- Fig. 5: an illustration of 200 samples of load current;
- Fig. 6: an illustration of two verification profiles for both triggering and non-triggering current profile;
- Fig. 7: a flow diagram illustrating a method for determining a state of an arrangement of electric and/or electronic components according to various embodiments;
- Fig. 8: an illustration of a cellular neural network, which may be used as the machine learning method according to various embodiments;
- Fig. 9: an illustration of a neural network with an internal memory, which may be used as the machine learning method according to various embodiments;
- Fig. 10: a state determination system according to various embodiments; and
- Fig. 11: a computer system with a plurality of computer hardware components configured to carry out steps of a computer implemented method for determining a state of an arrangement of electric and/or electronic components according to various embodiments.

### DETAILED DESCRIPTION

Input currents of different loads and consumers within the vehicle are commonly supplied by relays and melting fuses since. According to various embodiments, electronic circuits may observe the load current and may detach the load from wiring harness of a vehicle in case of overcurrent detection.

All formerly used methods have the disadvantage that either they are based on thermal heating due to occurred overcurrent (slow process and unreliable) or a simple threshold exceed is detected and the system decides to simply turn off the load, to faster protect the wiring harness. In reality, a lot current profile characteristics may occur which may be dependent on load type, attached wiring harness length, environmental temperature and vehicle supply voltage level and many more.

According to various embodiments, an intelligent and adaptable way is provided to ensure highest load availability for increasing protection level of the wiring harness and to be flexible enough against environmental changes.

Various embodiments may improve standard fusing devices, smart fusing devices and existing circuits for protecting the wiring harness and attached loads against overcurrents and even short circuits.

Various embodiments may be used for systems and module features needed in future beside fusing strategies, where short reaction times and adaptability to changes of a physical value within a certain time (profiles) should be applied.

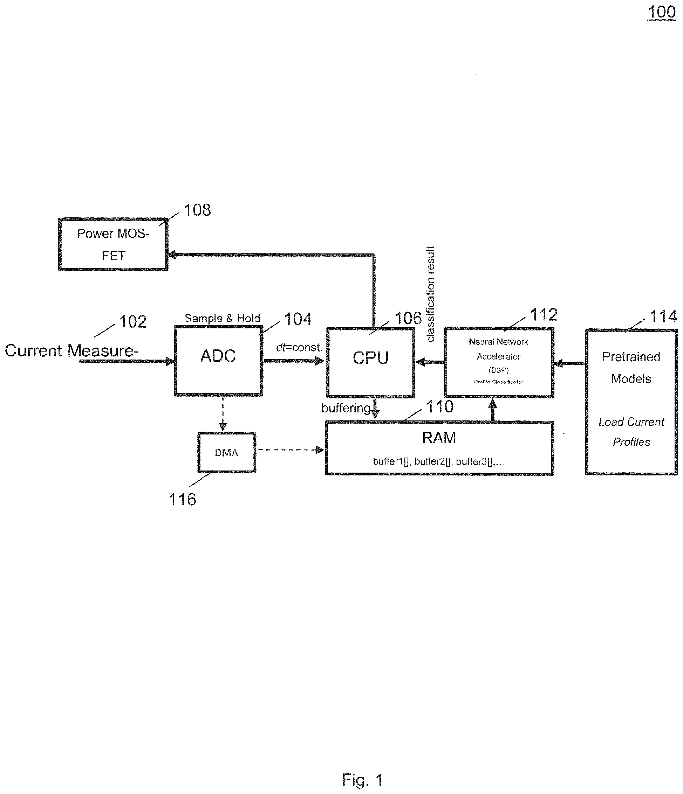

Fig. 1 shows a block diagram 100 illustrating an electronic load current profile classification system according to various embodiments, for example using circuit components and a heterogeneous microprocessor structure, including a neural network accelerator 112 (which may include a neural processing unit and/or a numeric processing unit and/or a DSP (digital signal processor), and which may provide profile classification).

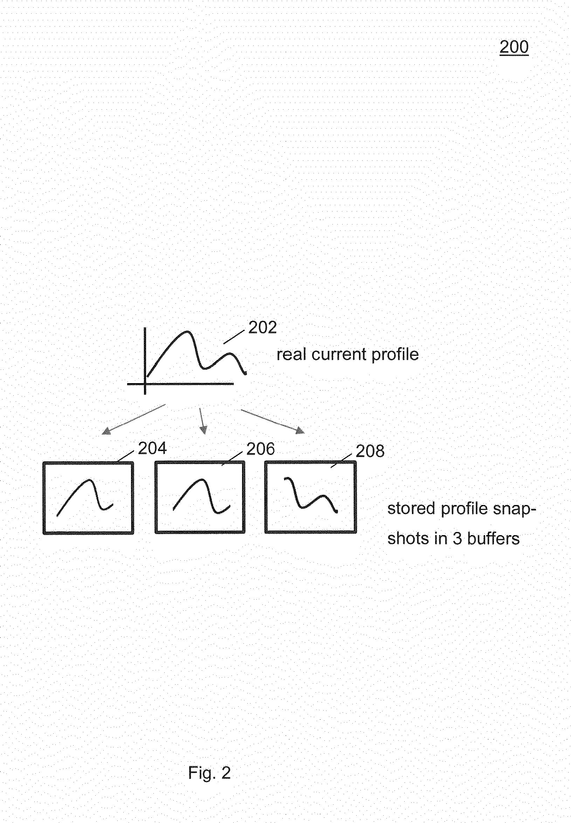

Incoming samples of a load current measurement 102 may be handled by an Analog-to-Digital-Converter (ADC) module 104. The samples may be taken in equal time intervals *dt* and may be handed over to a central processing unit 106 (which may be referred to as a processor). The samples may include integer values, which may be buffered into a random access memory (RAM) storage 110. According to various embodiments, the samples may be (directly) provided from the ADC 106 to the RAM 110 by DMA 116 (direct memory access). The RAM storage 110 may be configured as ringbuffer structures of several counts. Every filled buffer may contain a snapshot of the measured current profile. To ensure that all important parts of the profile are properly post-processed and classified, there may be overlapping parts between the several buffers, like illustrated in Fig. 2. For example, for realization of fast throughput and low CPU load, DMA may be used for ADC data exchange to RAM fetched by the NPU/DSP unit.

Fig. 2 shows an illustration 200 of overlap of load current measurements in various snapshots. For example, a real (or actual) current profile 202 is shown, and three profile snapshots 204, 206, 208 which may be stored in three buffers, are illustrated. There is a (temporal) overlap between the snapshots.

Returning to Fig. 1, a neural network computing unit 112 may fetch the contents of the several ring buffers from the RAM 110, and may classify the contents using a pretrained CNN (for example a convolutional neural network or a cellular neural network)) model 114.

The (artificial) neural network may be a CNN constellated as 3x3 cascade. Also, LSTM (long short-term memory) could be used, for example if there is a higher focus on time-based dependencies.

The (artificial) neural network may receive a time series of measurement data. Alternatively, the (artificial) neural network may receive measurement data for each time individually, and may have an internal memory; for example, the (artificial) neural network may be a recurrent neural network (RNN).

The pretrained model 114 may be generated out of several tens and hundreds of measured load current profiles in laboratory test fields, for example generated with application specific wiring harness, supply parameters and load properties.

If the classification reflects a certain probability that the pretrained CNN model 114 is overlapping with buffer contents, this result may be reported as positive detection to the processor CPU 106 (which may act as a safety controller). The method may then be receiving this signal and may decide how to react. For example, the absolute current level may additionally be checked, for example by a state machine.

The pretrained model 114 may mainly be focused on certain trends that will probably lead to overcurrents caused by failures or even short circuits to realize wireguard system that is fast enough to protect the wiring harness before overheating.

Furthermore, a following state machine may be used for failure mitigation in case the CNN accelerator 112 is signaling an overcurrent trend.

Based on the classification results, the CPU may control a power switch 108, for example a power MOSFET (metal oxide semiconductor field-effect transistor) switch.

In the following, training of a network (for example neural network) according to various embodiments will be described.

In a first step to generate a machine learning model, data from the field application may be taken. For this approach, the same components of the wiring system may be used and a continuous measurement may be realized to record all possible behaviors on the line.

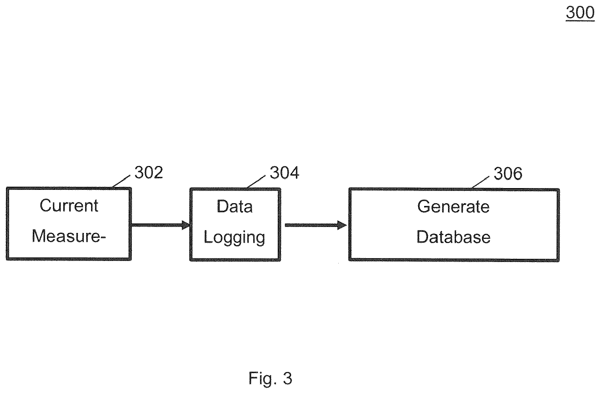

Fig. 3 shows an illustration 300 of a physical measurement and logging procedure according to various embodiments. A current measurement 302 may be provided to data logging 304, and based on the logged data, a database (for example including raw data) may be generated (306).

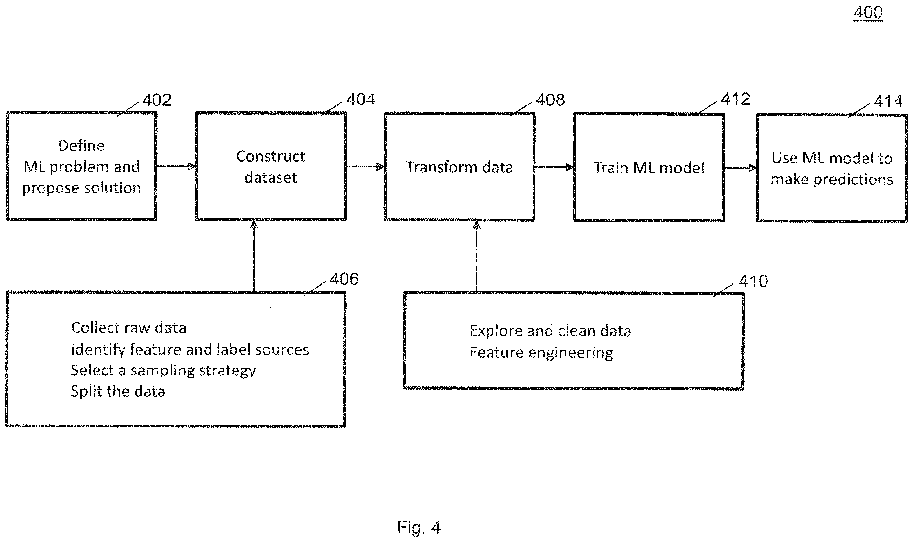

Fig. 4 shows an illustration 400 of how a machine learning model (for example a neural network) is trained. At 402, a machine learning problem may be defined and a solution may be proposed. At 404, a data set may be constructed. At 40, raw data may be collected, feature and label sources may be identified, a sampling strategy may be selected, and the data may be split. At 408, data may be transformed. At 410, data may be explored and cleaned and feature engineering may be performed. At 412, the machine learning model may be trained. At 414, the (trained) machine learning model may be used to make predictions.

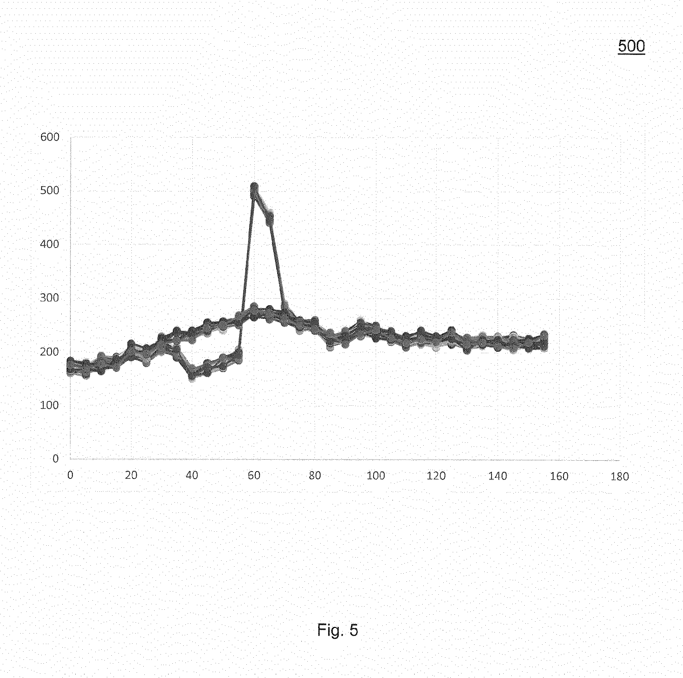

Fig. 5 shows an illustration 500 of a plurality of samples of load current. The high peak current values should trigger the fuse function of the system. It can be seen that the current is shortly increased and lowers itself afterwards. It then reaches an average current which was slightly higher than in the beginning of the scenario. Those logged datasets are used to train a neural network in the next step.

Depending on the number of taken samples and the data length as well the complexity of the curve behaviours it has to be judged into which model the neural network has to be trained in. Mainly the decision of layer counts and the used activation functions have to be chosen right to generate a reproducible functionality of the network.

In the following, an inference output of the used ML (machine learning) model will be described.

In addition to the trained model, a verification script may be generated that binds in the machine learning model as .tflite file and executes it with an arbitrary test current profile. This approach may be seen as a kind of model validation, to see if the idea behind this concept works fine.

One can then directly check the probability of the existence of a dangerous current profile, on which the fuse should trigger on.

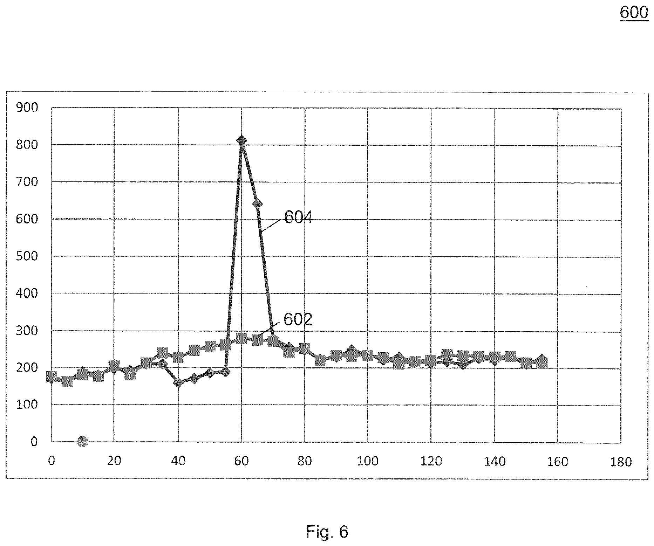

Fig. 6 shows an illustration 600 of two verification profiles for both triggering and non-triggering current profile. A first profile 604 shows a profile sample on which the controller should enable the fusing mechanism: Detection probability was calculated with 95% by the trained model. A second profile 602 shows a profile sample on which the controller should not enable the fusing mechanism an current proceeds to flow: Detection probability was calculated with 5% by the trained model.

According to various embodiments, the model may be used on a microcontroller system. As soon as the model is trained and validated, it may be deployed on a microprocessor or even microcontroller system. In case a smaller controller should be used, tensorflow-lite micro libraries may be used, which may be focused on supporting those systems with smaller memory and computation capabilities.

According to various embodiments, neural nets (neural networks) may be used for recognizing current profiles, to be prealarmed for possible faults on the supply system.

The neural net may be trained with existing measurement samples and a model may be generated that knows that such profiles can exist in case a module changes its internal function (for example when the current increases shortly). It may be the case that the current level exceeds a specific limit of capabilities, e.g. wiring harness current load, but only for very short time.

The model can be trained to be prealarmed if such increases are presen.t

By this approach the limit exceed is tolerated and no overcurrent detection is generated.

In case the same limit is exceeded with another characteristic like shorter or even longer current increase, the model and the microcontroller may be smart enough to detect it as unregularity and protect load as well as wiring harness by switching off the supply path.

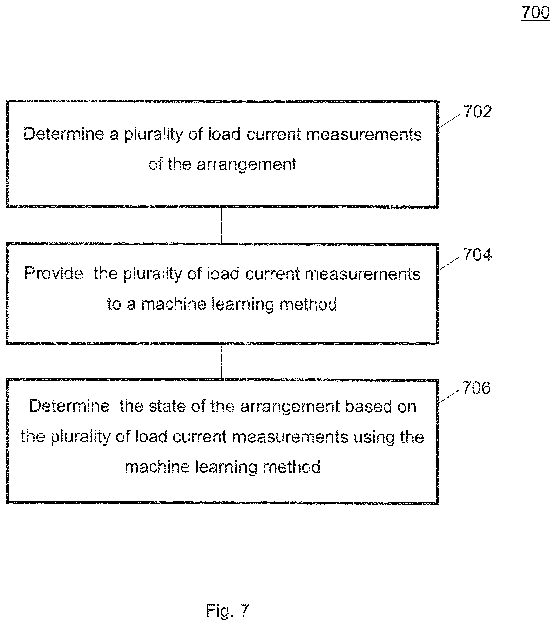

Fig. 7 shows a flow diagram 700 illustrating a method for determining a state of an arrangement of electric and/or electronic components according to various embodiments. At 702, a plurality of load current measurements of the arrangement may be determined. At 704, the plurality of load current measurements may be provided to a machine learning method. At 706, the state of the arrangement may be determined based on the plurality of load current measurements using the machine learning method.

According to various embodiments, determining the state of the arrangement may include or may be classifying the state of the arrangement into one of a plurality of classes.

According to various embodiments, the classes may include or may be a class of overload state and a class of non-overload state.

According to various embodiments, the classes may include or may be a class of fully charged and a class of not fully charged.

According to various embodiments, the plurality of load current measurements may include or may be a plurality of series of load current measurements, each series including a pre-determined number of subsequent load current measurements.

According to various embodiments, the plurality of series may overlap in time.

According to various embodiments, the machine learning method may include or may be a method using an artificial neural network.

According to various embodiments, the artificial neural network may include or may be a convolutional neural network.

According to various embodiments, the convolutional neural network may include or may be a network with a 3x3 cascade.

According to various embodiments, the artificial neural network may include or may be a long short-term memory.

Each of the steps 702, 704, 706 and the further steps described above may be performed by computer hardware components.

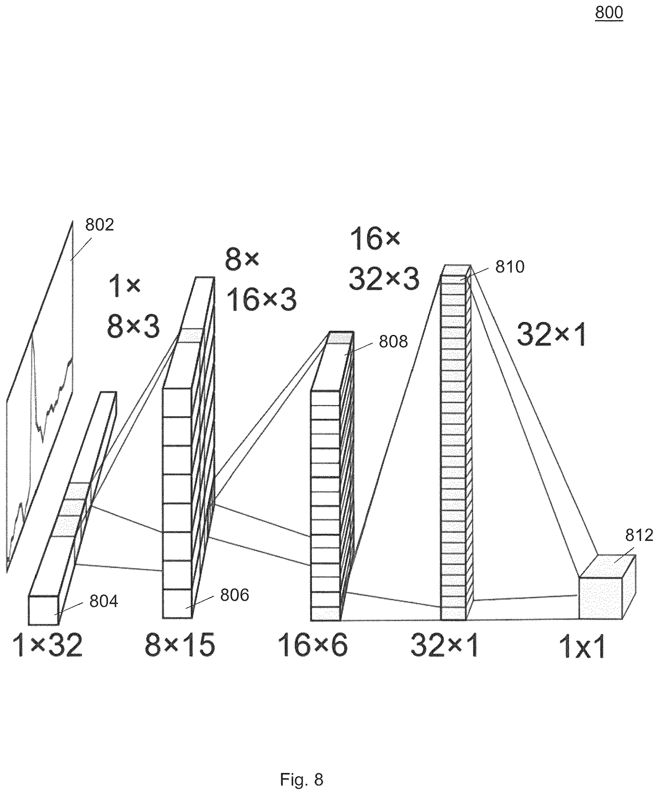

Fig. 8 shows an illustration 800 of a cellular neural network (CNN), which may be used as the machine learning method according to various embodiments. A time series 802 (in other words: data over a plurality of time points) may be received as an input, and may be provided as a first layer 804. It can be seen that the information gradually moves from spatial (time domain) encoding (in layer 804) into an orthogonal feature dimension (layer 810, via layers 806 and 808) before being combined into a (scalar) decision 812.

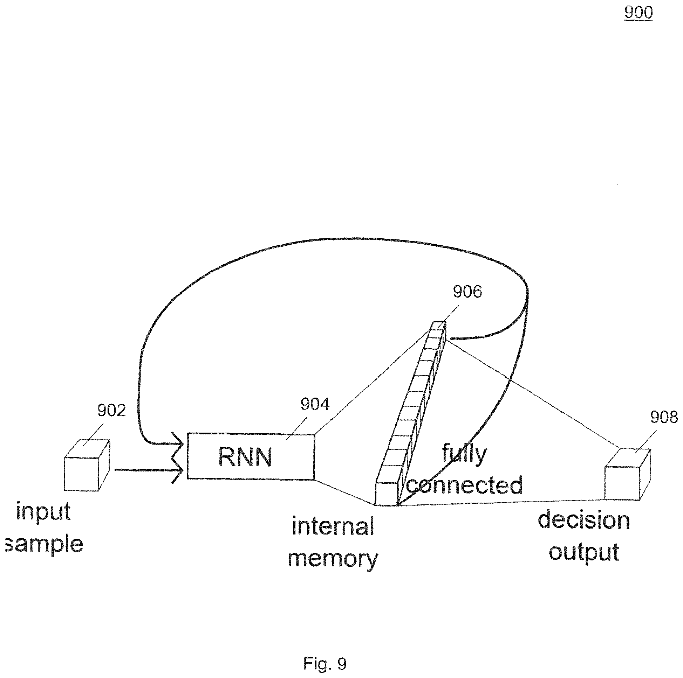

Fig. 9 shows an illustration 900 of a neural network with an internal memory, which may be used as the machine learning method according to various embodiments. The neural network shown in Fig. 9 may be a RNN (recurrent neural network) 904. Variant of RNNs may include LSTMs (long short term memories) and GRUs (gated recurrent units). The RNN 904 may receive a single sample 904 at each time, and an internal memory 906, which may be connected to the RNN 904 as shown in Fig. 9 (or which may be included in the RNN 904), and which may be fully connected as a further input of the RNN 904 may be provided, (and the internal memory of the last step) for input. The output decision 908 may be based on the internal memory 906 (which may also be referred to as internal state).

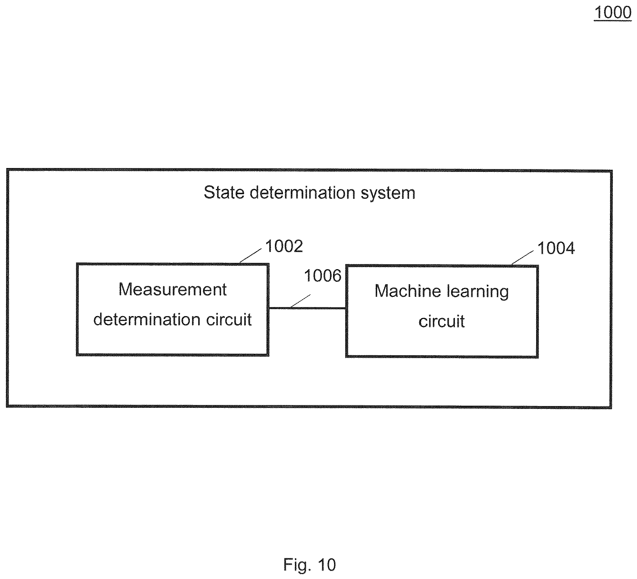

Fig. 10 shows a state determination system 1000 according to various embodiments. The state determination system 1000 may include a measurement determination circuit 1002 and a machine learning circuit 1004.

The measurement determination circuit 1002 may be configured to determine a plurality of load current measurements of an arrangement of electric and/or electronic components.

The machine learning circuit 1004 may be configured to determine the state of the arrangement based on the plurality of load current measurements.

The measurement determination circuit 1002 and the machine learning circuit 1004 may be coupled with each other, e.g. via an electrical connection 1006, such as e.g. a cable or a computer bus or via any other suitable electrical connection to exchange electrical signals.

A "circuit" may be understood as any kind of a logic implementing entity, which may be special purpose circuitry or a processor executing a program stored in a memory, firmware, or any combination thereof.

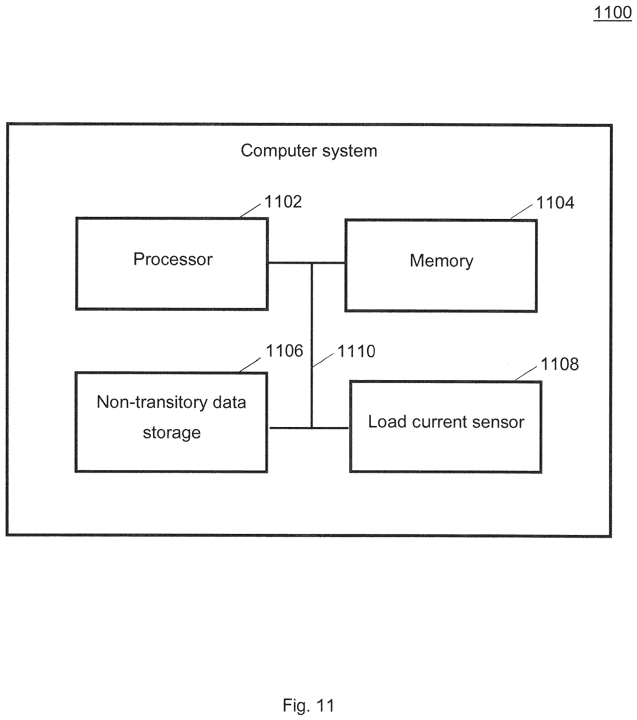

Fig. 11 shows a computer system 1100 with a plurality of computer hardware components configured to carry out steps of a computer implemented method for determining a state of an arrangement of electric and/or electronic components according to various embodiments. The computer system 1100 may include a processor 1102, a memory 1104, and a non-transitory data storage 1106. A load current sensor 1108 may be provided as part of the computer system 1100 (like illustrated in Fig. 11), or may be provided external to the computer system 1100.

The processor 1102 may carry out instructions provided in the memory 1104. The non-transitory data storage 1106 may store a computer program, including the instructions that may be transferred to the memory 1104 and then executed by the processor 1102. The load current sensor 1108 may be used for determining or measuring) a current (which may be referred to as load current), for example a current related to a power consumed by one or more load of the arrangement.

The processor 1102, the memory 1104, and the non-transitory data storage 1106 may be coupled with each other, e.g. via an electrical connection 1110, such as e.g. a cable or a computer bus or via any other suitable electrical connection to exchange electrical signals. The load current sensor 1108 may be coupled to the computer system 1100, for example via an external interface, or may be provided as parts of the computer system (in other words: internal to the computer system, for example coupled via the electrical connection 1110).

The terms "coupling" or "connection" are intended to include a direct "coupling" (for example via a physical link) or direct "connection" as well as an indirect "coupling" or indirect "connection" (for example via a logical link), respectively.

It will be understood that what has been described for one of the methods above may analogously hold true for the state determination system 1000 and/or for the computer system 1100.

### Reference numeral list

- 100: block diagram illustrating an electronic load current profile classification system according to various embodiments
- 102: load current measurement
- 104: ADC module
- 106: central processing unit
- 108: power switch
- 110: storage
- 112: neural network accelerator
- 114: CNN model
- 116: DMA

- 200: illustration of overlap of load current measurements in various snapshots
- 202: real current profile
- 204: profile snapshot
- 206: profile snapshot
- 208: profile snapshot

- 300: illustration of a physical measurement and logging procedure according to various embodiments
- 302: current measurement
- 304: data logging
- 306: generation of database

- 400: illustration of how a machine learning model is trained
- 402: define machine learning problem and propose solution
- 404: construct data set
- 406: collect raw data et al
- 408: transform data
- 410: explore and clean data and feature engineering
- 412: train machine learning model
- 414: use machine learning model to make predictions

- 500: illustration of 200 samples of load current

- 600: illustration of two verification profiles for both triggering and non-triggering current profile
- 602: second profile
- 604: first profile

- 700: flow diagram illustrating a method for determining a state of an arrangement of electric and/or electronic components according to various embodiments
- 702: step of determining a plurality of load current measurements of the arrangement
- 704: step of providing the plurality of load current measurements to a machine learning method
- 706: step of determining the state of the arrangement based on the plurality of load current measurements using the machine learning method

- 800: illustration of a cellular neural network, which may be used as the machine learning method according to various embodiments
- 802: time series
- 804: layer
- 806: layer
- 808: layer
- 810: layer
- 812: decision

- 900: illustration of a neural network with an internal memory, which may be used as the machine learning method according to various embodiments
- 902: input sample
- 904: recurrent neural network
- 906: internal memory
- 908: decision output

- 1000: state determination system
- 1002: measurement determination circuit
- 1004: machine learning circuit
- 1006: connection

- 1100: computer system according to various embodiments
- 1102: processor
- 1104: memory
- 1106: non-transitory data storage
- 1108: load current sensor
- 1110: connection

## Claims

1. Computer implemented method for determining a state of an arrangement of electric and/or electronic components,
the method comprising the following steps carried out by computer hardware components:
- determining (702) a plurality of load current measurements of the arrangement, wherein the plurality of load current measurements comprises a plurality of series of load current measurements, each series comprising a pre-determined number of subsequent load current measurements;
- providing (704) the plurality of load current measurements to a machine learning method, wherein the machine learning method comprises a method using an artificial neural network; and
- determining (706) the state of the arrangement based on the plurality of load current measurements using the machine learning method;
wherein determining the state of the arrangement comprises classifying the state of the arrangement into one of a plurality of classes; and
wherein the classes comprise:
a class of overload state and a class of non-overload state; or
a class of fully charged and a class of not fully charged; or.
a plurality of classes corresponding to pre-determined percentages of full charging.

2. The computer implemented method of claim 1,
wherein the plurality of series overlap in time.

3. The computer implemented method of at least one of claims 1 or 2,
wherein the artificial neural network comprises a convolutional neural network.

4. The computer implemented method of claim 3,
wherein the convolutional neural network comprises a network with a 3x3 cascade.

5. The computer implemented method of at least one of claims 1 to 4,
wherein the artificial neural network comprises a long short-term memory.

6. Computer system (1100), the computer system (1100) being configured to carry out the computer implemented method of at least one of claims 1 to 5.

7. The computer system (1100) of claim 6, further comprising:
a digital signal processor configured to carry out the machine learning method.

8. Vehicle comprising the computer system (1100) of claim 6 and a sensor configured to determine the plurality of load current measurements of the arrangement.

9. Battery charger comprising the computer system (1100) of claim 6 and a sensor configured to determine the plurality of load current measurements of the arrangement.

10. Non-transitory computer readable medium comprising instructions for carrying out the computer implemented method of at least one of claims 1 to 5 on a computer system.

## Patentansprüche

1. Computerimplementiertes Verfahren zum Bestimmen eines Zustands einer Anordnung von elektrischen und/oder elektronischen Komponenten,
wobei das Verfahren die folgenden Schritte umfasst, die von Computerhardwarekomponenten ausgeführt werden:
- Bestimmen (702) einer Vielzahl von Laststrommessungen der Anordnung, wobei die Vielzahl von Laststrommessungen eine Vielzahl von Reihen von Laststrommessungen umfasst, wobei jede Reihe eine vorbestimmte Anzahl von nachfolgenden Laststrommessungen umfasst;
- Bereitstellen (704) der Vielzahl von Laststrommessungen für ein maschinelles Lernverfahren, wobei das maschinelle Lernverfahren ein Verfahren umfasst, das ein künstliches neuronales Netzwerk verwendet; und
- Bestimmen (706) des Zustands der Anordnung basierend auf der Vielzahl von Laststrommessungen unter Verwendung des maschinellen Lernverfahrens;
wobei das Bestimmen des Zustands der Anordnung das Klassifizieren des Zustands der Anordnung in eine von einer Vielzahl von Klassen umfasst; und
wobei die Klassen umfassen:
eine Klasse eines Überlastzustands und eine Klasse eines Nicht-Überlastzustands; oder
eine Klasse voll geladen und eine Klasse nicht voll geladen; oder
eine Vielzahl von Klassen, die vorbestimmten Prozentsätzen des Vollladens entsprechen.

2. Computerimplementiertes Verfahren nach Anspruch 1,
wobei sich die Vielzahl von Reihen zeitlich überlappen.

3. Computerimplementiertes Verfahren nach mindestens einem der Ansprüche 1 oder 2,
wobei das künstliche neuronale Netzwerk ein neuronales Faltungsnetzwerk umfasst.

4. Computerimplementiertes Verfahren nach Anspruch 3,
wobei das neuronale Faltungsnetzwerk ein Netzwerk mit einer 3x3-Kaskade umfasst.

5. Computerimplementiertes Verfahren nach mindestens einem der Ansprüche 1 bis 4,
wobei das künstliche neuronale Netzwerk einen langen Kurzzeitspeicher umfasst.

6. Computersystem (1100), wobei das Computersystem (1100) konfiguriert ist, um das computerimplementierte Verfahren nach mindestens einem der Ansprüche 1 bis 5 auszuführen.

7. Computersystem (1100) nach Anspruch 6, ferner umfassend:
einen digitalen Signalprozessor, der konfiguriert ist, um das maschinelle Lernverfahren auszuführen.

8. Fahrzeug, umfassend das Computersystem (1100) nach Anspruch 6 und einen Sensor, der konfiguriert ist, um die Vielzahl von Laststrommessungen der Anordnung zu bestimmen.

9. Batterieladegerät, umfassend das Computersystem (1100) nach Anspruch 6 und einen Sensor, der konfiguriert ist, um die Vielzahl von Laststrommessungen der Anordnung zu bestimmen.

10. Nichtflüchtiges computerlesbares Medium, das Anweisungen zum Ausführen des computerimplementierten Verfahrens nach mindestens einem der Ansprüche 1 bis 5 auf einem Computersystem umfasst.

## Revendications

1. Procédé mis en oeuvre par ordinateur pour déterminer l'état d'un agencement de composants électriques et/ou électroniques,
le procédé comprenant les étapes suivantes exécutées par des composants matériels de l'ordinateur, consistant à :
- déterminer (702) une pluralité de mesures de courant de charge de l'agencement, la pluralité de mesures de courant de charge comprenant une pluralité de séries de mesures de courant de charge, chaque série comprenant un nombre prédéterminé de mesures de courant de charge subséquentes ;
- fournir (704) la pluralité de mesures de courant de charge à un procédé d'apprentissage automatique, le procédé d'apprentissage automatique comprenant un procédé utilisant un réseau neuronal artificiel ; et
- déterminer (706) l'état de l'agencement sur la base de la pluralité de mesures de courant de charge à l'aide du procédé d'apprentissage automatique ;
dans lequel la détermination de l'état de l'agencement comprend la classification de l'état de l'agencement dans l'une d'une pluralité de classes ; et
dans lequel les classes comprennent :
une classe d'état de surcharge et une classe d'état de non-surcharge ; ou
une classe de charge complète et une classe de charge incomplète ; ou
une pluralité de classes correspondant à des pourcentages prédéterminés de charge complète.

2. Procédé mis en oeuvre par ordinateur selon la revendication 1,
dans lequel la pluralité de séries se chevauchent dans le temps.

3. Procédé mis en oeuvre par ordinateur selon au moins l'une des revendications 1 ou 2,
dans lequel le réseau neuronal artificiel comprend un réseau neuronal convolutif.

4. Procédé mis en oeuvre par ordinateur selon la revendication 3,
dans lequel le réseau neuronal convolutif comprend un réseau avec une cascade 3×3.

5. Procédé mis en oeuvre par ordinateur selon au moins l'une des revendications 1 à 4,
dans lequel le réseau neuronal artificiel comprend une longue mémoire court terme.

6. Système informatique (1100), le système informatique (1100) étant configuré pour exécuter le procédé mis en oeuvre par ordinateur selon au moins l'une des revendications 1 à 5.

7. Système informatique (1100) selon la revendication 6, comprenant en outre :
un processeur de signaux numériques configuré pour exécuter le procédé d'apprentissage automatique.

8. Véhicule comprenant le système informatique (1100) selon la revendication 6 et un capteur configuré pour déterminer la pluralité de mesures de courant de charge de l'agencement.

9. Chargeur de batterie comprenant le système informatique (1100) selon la revendication 6 et un capteur configuré pour déterminer la pluralité de mesures de courant de charge de l'agencement.

10. Support non transitoire lisible par ordinateur comprenant des instructions pour exécuter le procédé mis en oeuvre par ordinateur selon au moins l'une des revendications 1 à 5 sur un système informatique.
